# EUROPEAN PATENT APPLICATION

(11) **EP 4 354 223 A1**
(43) Date of publication of application: **17.04.2024**
(21) Application number: 22819521.0
(22) Date of filing: 07.06.2022
(51) Int. Cl.: G03F 7/16, G03F 7/20, G03F 7/30

(54) **PHOTOLITHOGRAPHY METHOD BASED ON BILAYER PHOTORESIST**

(30) Priority: 11.06.2021 CN 202110653553
(71) Applicant: Shanghai Microstart Photoelectric Technology Co., Ltd, Shanghai 201805 (CN)
(72) Inventor: GAO, Yijiao, Shanghai 201805 (CN)
(74) Representative: Jacobs, Lambert
(86) International application number: PCT/CN2022/097391
(87) International publication number: WO 2022/257923

(57) **Abstract**

The present invention pertains to a photolithography method based on bilayer photoresist, the method comprising the following steps: (1) applying one layer of positive photoresist on a substrate and drying, then applying one layer of negative photoresist on the positive photoresist and drying; (2) exposing the two layers of photoresist using a photolithography mask with mask patterns or through focused direct write under a source of exposure, and then drying; (3) developing, with developer for negative photoresist, the negative photoresist; (4) controllably developing, with developer for positive photoresist, the positive photoresist; (5) forming patterns on the material of the substrate through material deposition technology or etching technology; (6) removing the photoresist. Compared with existing single-exposure photolithography technology, the method of the present invention is simple and a line width smaller than that of the conventional technology can be achieved by pattern contouring. The method can be widely used in semiconductor process and has extensive values of research and application.

## Description

### Technical Field

The present invention pertains to the technical field of processing of semiconductor microstructure, and specifically pertains to a photolithography method based on bilayer photoresist.

### Technical Background

The rapid development of integrated circuits relies on the development of related manufacturing process - photolithography, which is processing technology which can reach the highest precision up to now. Photolithography is a precise fine processing technique. Conventional photolithography technology applies ultraviolet (UV) rays of a wavelength of 135-4500 Å as carriers for image information and applies photoinduced resist as an intermediate or image recording medium to transform, transfer and process patterns and eventually transfer information of image to a wafer, which mainly refers to a process on a silicon wafer or a medium layer.

In principle, the technology of photolithography refers to the technology to transfer the patterns on a mask to a substrate by means of photo-induced resists (also known as photoresists) under illumination of radiation. Its main process is as follows: first, ultraviolet rays travel through a mask and illuminates a surface of a substrate attached with a layer of photoresist film, which causes chemical reactions to occur in photoresists in the exposed region; then the photoresists in the exposed region or the unexposed region to be removed through dissolution by developing technology, so that the patterns on the mask are duplicated to the film of the photoresists; finally, the patterns are transferred to a substrate through etching technology. The photoresists can mainly divided into positive photoresists and negative photoresists. The positive photoresists are characterized by its exposed portions being dissolved in the developer due to photochemical reactions occurring in the portions, while its portions not exposed not being dissolved in the developer. Negative photoresists are characterized by its exposed portions not being dissolved in the developer due to cross-linking solidity or photochemical reactions, while its unexposed portions being dissolved in the developer.

Photolithography is the most important processing in integrated circuits, similar to the role of a lathe for a metal workshop. Implementation of almost each process in the entire process of chip manufacturing would not be possible in the absence of photolithography technology. Photolithography is also the most critical technology in chip manufacturing and occupies over 35 percent of the costs for chip manufacturing.

The photolithography technology can mainly be categorized as optical lithography, for which common light sources include ultraviolet (UV) light source, deep ultraviolet (DUV) light source, extreme ultraviolet (EUV) light source, and particle beam lithography, common example for which mainly include X-ray lithography, electron beam lithography and ion beam lithography, etc.

Generally, UV can only implement a resolution of about one micro for the patterns in optical lithography. Although a higher resolution can be implemented by DUV, EUV, etc., expensive machines, which can only be affordable by giants in the industry, need to be used. In addition, although electron beam lithography and focused ion beam lithography can also increase the resolution to some degree in particle beam lithography, the time-consuming writing process of multiple cycles is needed, which substantially reduce efficiency of work.

### Summary

The purpose of the present invention is to overcome the deficiencies in prior arts as described above and to provide a photolithography method based on bilayer photoresist which is simple, achieves smaller width of lines than conventional technology, can be widely used in semiconductor process and has extensive values of research and application.

The purpose of the present invention can be implemented by the following technical solutions:
Patterns of contour lines based on the features of original patterns are obtained by making use of positive and negative photoresists, i.e., difference of the responses of positive and negative photoresists to light source and difference of exposure energy obtained during exposure and making use of difference of sizes of patterns of matching positive and negative photoresists after actual developing to achieve contour lines of line width smaller than the line width of the features of the original patterns and multiplication of density of lines. Thereafter, the patterns can be further transferred to the target material by combining etching process for substrate material or deposition material. The specific solution is as follows.

A photolithography method based on bilayer photoresist, comprising the following steps:
(1) cleaning a material of a substrate, then applying one layer of positive photoresist on the substrate, and drying; further applying one layer of negative photoresist on the positive photoresist, and drying;
(2) exposing two layers of photoresists using photolithography masks with mask patterns or through focused direct write under a source of exposure; after exposure, forming exposure patterns of different sizes on the negative photoresist and the positive photoresist respectively, and then drying;
( 3 ) developing the negative photoresist with developer for negative photoresist;
(4) controllably developing the positive photoresist with developer for the positive photoresist to merely wash away edge portions of the exposure patterns on the positive photoresist and uncover the material of the substrate;
(5) forming patterns on the material of the substrate through material deposition technology or etching technology;
(6) removing the photoresist.

Further, transforming mask patterns to patterns of contour lines by performing the above step (4); transferring the patterns of contour lines to the material of the substrate by performing the above step (5).

Further, the material of the substrate includes semiconductor, metal, insulator, polymer or composite material. For example, a silicon wafer or a silicon wafer with one layer of silicon oxide film attached on its surface.

Further, the method of transferring the patterns of contour lines obtained after bilayer photolithography is performed on the substrate of the silicon wafer to the deposition material comprises the following steps:
(1) spin coating positive photoresist: placing the silicon wafer that has been cleaned in a spin coater and fixing it in vacuum; spin coating the photoresist by spray coating or drop coating the positive photoresist, and drying;
(2) spin coating negative photoresist: placing the silicon wafer that has been cooled in a spin coater and fixing it in vacuum; spin coating the negative photoresist by spray coating or drop coating the negative photoresist, and drying;
(3) exposure: tightly fixing the substrate of the silicon wafer that has undergone the above steps on an exposure stage and right under the source of exposure, turning on a light source, performing exposure through a mask or an apparatus for focusing the source of exposure, adjusting exposure time or exposure dose according to a kind of paired group of photoresist and a thickness of the layer of photoresist; after exposure is finished, moving the exposed silicon wafer to a heating stage for drying;
(4) developing

After post-drying is finished and the silicon wafer has been cooled to the room temperature, performing developing respectively with the following process: placing the silicon wafer after photolithograph in developer for negative photoresist and causing the unexposed negative photoresist on the silicon wafer to be washed away; then taking out the silicon wafer, cleaning it with deionized water and drying it with a flow of nitrogen; (Note: the steps of cleaning with deionized water can be omitted if the developer is same for positive and negative photoresist)

Further placing the silicon wafer to developer for positive photoresist, while not completely removing the unexposed positive photoresist under the exposed negative photoresist; then taking out the silicon wafer, cleaning it with deionized water and drying it with nitrogen, producing patterns of contour lines based on the mask patterns;
(6) material deposition (taking metal material as an example): placing the silicon wafer that has been developed in an evaporation coater, thermally evaporating a titanium film of 5 nm and a gold film of 50 nm respectively, the titanium film of 5 nm used as an adhesion layer for the gold film.
(7) removing the photoresist: after the chamber is cooled, releasing vacuum in the chamber and taking out the coated silicon wafer. Immersing the silicon wafer in the acetone, untrasonic cleaning it until the photoresist is completely removed, leaving patterns of metal contour lines.

Further, the method of producing patterns of silicon oxide on the surface of the silicon wafer with thick silicon film grown on its surface comprises the following steps:
(1) spin coating positive photoresist: spin coating positive photoresist for the silicon wafer of silicon oxide, and then baking;
(2) spin coating negative photoresist: placing the silicon wafer that has been cooled in a spin coater and fixing it in vacuum; spin coating negative photoresist, and baking;
(3) exposure: tightly fixing the substrate of the silicon wafer that has undergone the above steps on an exposure stage and right under the source of exposure, turning on a light source, performing exposure through a mask or an apparatus for focusing the source of exposure, adjusting exposure time or exposure dose according to a kind of paired group of photoresist and the thickness of the layer of photoresist; after exposure is finished, moving the exposed silicon wafer to a heating stage for drying;
(4) developing

After post-drying is finished and the silicon wafer has been cooled to the room temperature, performing developing respectively with following process: placing the silicon wafer after photolithograph in developer for negative photoresist and causing the unexposed negative photoresist on the silicon wafer to be washed away; then taking out the silicon wafer, cleaning it with deionized water and drying it with a flow of nitrogen; (Note: the steps of cleaning with deionized water and drying with nitrogen can be omitted if the developer is same for positive and negative photoresist)

Further placing the silicon wafer to developer for positive photoresist, while not completely removing the unexposed positive photoresist under the exposed negative photoresist; then taking out the silicon wafer, cleaning it with deionized water and drying it with nitrogen, producing patterns of contour lines based on the mask patterns;
(5) dry etching: placing the silicon in an ion etcher, etching the mask layer of silicon dioxide with plasma gas to remove the layer of silicon dioxide that has been deposited in advance at the patterns of lines of square contour, causing the underlying silicon substrate to be uncovered.
(6) removing the photoresist: immersing the silicon wafer in acetone, ultrasonic cleaning it under the photoresist is completely removed so as to produce lines of square contour of silicon dioxide.

Further, the process of spin coating comprises: spin coating at a rotation speed of 500-8000 rpm, and the temperature for drying after the spin coating is 30 °C - 300 °C.

Even further, the process of spin coating comprises: spin coating at a rotation speed of 2000-8000 rpm for 30-40 seconds, and the temperature for drying after the spin coating is 90-100°C, the duration is 30-90 second.

Further, the exposing is in the form of single exposure.

Further, the exposing can also be in the form of multiple exposures. That is, the exposure can be implemented by being divided to a plurality of times of exposure of a plurality of shorter periods of time or smaller doses. Further, the source of exposure may be ultraviolet light source, deep ultraviolet light source, extreme ultraviolet light source, ion beam, electron beam or X-ray.

Further, the wavelength of the source of exposure is 1 -500 nm, and the temperature for the drying after the exposing is 30 -300°C.

Even further, the wavelength of the source of exposure is 350 -400 nm, and the temperature for the drying after the exposing is 95 -105°C.

Further, the positive photoresist includes positive ultraviolet photoresist, positive deep ultraviolet photoresist, positive extreme ultraviolet photoresist, positive electron beam photoresist, positive ion beam photoresist or positive X-ray photoresist, including photoresist of MICROPOSIT S1800 series, BCI-3511 photoresist, photoresist of AZ series (e.g., AZ111, AZ 1500, AZ 3300, AZ 4999, AZ 6600, AZ 8112, AZ 3000, AZ 1075, AZ 700, AZ 900), photoresist of HNR 500 series, photoresist of OiR series, Photoresist of TDMR-AR80 HP 6CP, PR1 series, photoresist of ma-P 1200 series, photoresist of SPR series (e.g., SPR 220, SPR 660, SPR3000 etc.), photoresist of PMMA series, etc.

The negative photoresist includes negative ultraviolet photoresist, negative deep ultraviolet photoresist, negative extreme ultraviolet photoresist, negative electron beam photoresist, negative ion beam photoresist or positive X-ray photoresist, including but not limited to NANO^{™} SU-8 Series, HSQ, photoresist of AZ series (e.g., AZ N4000, AZ N6000), photoresist of HNR series, photoresist of SC series, photoresist of ma-N series (e.g., ma-N 400, ma-N 1400), AZ^{®} nLOF^{®} 2000 Series, AZ^{®} nLOF^{®} 5500 Photoresist, NR7-PY Series, NR9-PY Series, JSR WPR Series, NR71 Series NR9 Series, etc.

Further, developer for photoresist is generally developer corresponding to the used photoresist. For example, the developer for positive photoresist may be TMAH 2.38%, MF-26A, and the developer for negative photoresist may be TMAH 2.38%, SU-8 developer, etc.

Further, the feature line width or feature dimension of mask patterns is 2 nm -1000 µm.

Even further, the feature line width or feature dimension of the mask patterns is 2 nm -1 µm.

Further, the material deposition technology includes but not limited to electrochemical deposition, electroplating, CVD deposition, laser sputtering, magnetron sputtering, thermal evaporation, electron beam evaporation or atomic deposition;

The etching technology includes wet etching including electrochemical etching or selective etching liquid etching or dry etching including ion etching or chemical reactive ion etching.

Further, projection exposure is applied in the step of exposure, and under the source of exposure, the two layers of photoresist are exposed through a photolithography mask carrying mask patterns

Further, masking exposure is applied in the step of exposure, and under the source of exposure, the two layers of photoresist are exposed through a photolithography mask with mask patterns

Further, reflection exposure is applied in the step of exposure, and under the source of exposure, the two layers of photoresist are exposed through reflection on a photolithography mask with mask patterns

Further, the focused direct write includes but not limited to ultraviolet direct write, deep ultraviolet direct write, extreme ultraviolet direct write, ion beam direct write, electron beam direct write or X-ray direct write.

Further, the material of the substrate includes semiconductor, metal, insulator, polymer or composite material.

The present invention also provides a photolithography system comprising a spin coating device, a drying device, an exposing device, a developing device, a deposition and etching device, and a photoresist removing device, the photolithography system used to perform the following steps:
(1) spin coating, by the spin coating device, one layer of positive photoresist on a substrate, and drying, by the drying device, the positive photoresist; spin coating, by the spin coating device, one layer of negative photoresist matching the positive photoresist on the positive photoresist, and drying, by the drying device, the negative photoresist;
(2) exposing, by the exposing device, two layers of photoresists using photolithography masks with mask patterns or through focused direct writing under the source of exposure, so as to form exposure patterns of different sizes on the negative photoresist and the positive photoresist respectively, and then drying, by the drying device, the negative photoresist and the positive photoresist;
(3) developing, by the developing device, the negative photoresist with developer for negative photoresist;
(4) controllably developing, by the developing device, the positive photoresist with developer for positive photoresist to merely wash away edge portions of the exposure patterns on the positive photoresist and uncover the material of the substrate;
(5) forming, by the deposition and etching device, patterns on the material of the substrate through material deposition technology or etching technology;
(6) removing, by the photoresist removing device, the photoresist.

The present invention also provide a method of controlling a photolithography system for controlling the steps performed by the photolithography system described above.

The present invention also provide a computer device comprising a memory, a processor, and computer program that is stored in the memory and can run on the processor, characterized in that the processor implements the method of controlling a photolithography system described above when executing the computer program.

The present invention also provides a computer readable medium having computer program stored thereon, which when executed by a processor implements the method of controlling photolithography system described above.

The present invention has the following advantages over prior arts:
(1) the present invention inherits the characteristics of high efficiency, low cost and simple operation of traditional photolithography, while curing the limitation of traditional photolithography in producing patterns of the resolution of submicron;
(2) the present invention achieves miniaturization of original mask patterns.

### Description of Figures

Fig. 1 is a flow schematic diagram in embodiment 1;
Fig. 2 is a flow schematic diagram in embodiment 2; and
Fig. 3 is a pattern of gold nanowire prepared in embodiment 1.

### Detailed Description

Next, the present invention is described in detail with reference to the drawings and specific embodiments. This embodiment is implemented based on the premise of the technical solutions of the present invention. Detailed implementations and specific operational processes are provided, but the protective scopes of the present invention are not limited to the embodiments as described below.

### <Photolithography Method Based on Bilayer Photoresist>

The present invention provides a photolithography method based on bilayer photoresist, comprising the following steps:
(1) applying one layer of positive photoresist on a substrate and drying;
   further applying one layer of negative photoresist on the positive photoresist and drying;
   the positive photoresist includes positive ultraviolet photoresist, positive deep ultraviolet photoresist, positive extreme ultraviolet photoresist, positive electron beam photoresist, positive ion beam photoresist or positive X-ray photoresist.the negative photoresist includes negative ultraviolet photoresist, negative deep ultraviolet photoresist, negative extreme ultraviolet photoresist, negative electron beam photoresist, negative ion beam photoresist or positive X-ray photoresist.

The matching degree for positive and negative photoresists of different Item No. needs to be confirmed in advance. Two paired groups of positive and negative photoresists are provided as follows: first group comprising positive photoresist of Item No. SPR 660 and negative photoresist of Item No. SU-8 2; second group comprising positive photoresist of Item No. AZ 1500 and negative photoresist of Item No. AZ nlof 2020.

The process of spin coating the positive photoresist (taking SPR 660, AZ 1500 as examples) is as follows: first spin coating the positive photoresist at a rotation speed of 800-1000 rotations/minute for 5-10 seconds (this step can be omitted); then spin coating the positive photoresist at a rotation speed of 2000-5000 rotations/minute for 30-40 seconds and baking the same at 90-100°C for 30-50 seconds.

The process of spin coating the negative photoresist (taking SU-8 2, AZ nlof 2020 as examples) is as follows: first spin coating the negative photoresist at a rotation speed of 800-1000 rotations/minute for 5-10 seconds (this step can be omitted); then spin coating the negative photoresist at a rotation speed of 4000-8000 rotations/minute for 30-40 seconds and baking the same at 95-100°C for 60-90 seconds. Different rotation speeds determine the degree of thickness of the film of photoresists.Pre-bake temperature and time and subsequent exposure amount, exposure time and developing time are adjusted according to different thickness of films.

The material of the substrate includes semiconductor, metal, insulator, polymer or composite material.

(2) Under the source of exposure, exposing two layers of photoresists once using photolithography masks with mask patterns or through focused direct write; after exposure, forming exposure patterns of different sizes on the negative photoresist and the positive photoresist respectively, and then drying the negative and positive photoresists; wherein the source of exposure include ultraviolet light source, deep ultraviolet light source, extreme ultraviolet light source, ion beam, electron beam or X-ray.Focused direct write includes ultraviolet direct write, deep ultraviolet direct write, extreme ultraviolet direct write, ion beam direct write, electron beam direct write or X-ray direct write. The feature line width or feature dimension of the mask patterns is 2 nm-1000 µm.

Fixing the pre-baked silicon wafer under the mask, then placing it under the ultraviolet light source, turn on the ultraviolet light source to perform photolithography, wherein the exposure time is adjusted according to the paired group of positive and negative photoresists that are used. Taking the pairing mentioned above as examples, the exposure amount of 100-200 mJ/cm² at the wavelength of 350-400 nm is applicable to the paired photoresist group of SPR 660 and SU-8 2, and the paired photoresist group of AZ 1500 and AZ nlof 2020.The absorption effect of negative photoresists (e.g., SU-8 2, AZ nlof 2020) of different thickness on ultraviolet radiation shall be taken into account for use of wavelength of UV and exposure flux to ensure that the underlying positive photoresist (e.g., SPR 660, AZ 1500) can obtain sufficient exposure flux.As the responses of the paired group of SPR 660 and SU-8 2 and the paired group of AZ 1500 and AZ nlof 2020 to the exposure flux at specific wavelengths are different, patterns of different sizes based on the mask patterns can be obtained.
( 3 ) developing the negative photoresist with developer for negative photoresist;
(4) controllably developing the positive photoresist with developer for positive photoresist to merely wash away the edge portions of the exposed patterns on the positive photoresist and uncover the material of the substrate, so as to transform the mask patterns to patterns of contour lines;

Taking the pairing mentioned above as examples, after exposure is finished, taking down the mask, moving the exposed silicon wafer to a heating stage, and baking it at 95-105 °C for 40-49 seconds.After post-drying is finished, performing developing respectively. The process is as follows: placing the silicon wafer after photolithography in corresponding developer for negative photoresist (e.g., SU-8 developer, TMAH-2.38%) to cause the unexposed negative photoresist to be washed away. Then, taking the silicon wafer out, cleaning it with water, and drying it with a flow of nitrogen; placing the silicon wafer in corresponding developer for positive photoresist (e.g., MF-26A, TMAH-2.38%) to cause the uncovered positive photoresist that has not been exposed to be washed away, meanwhile, not completely removing the unexposed negative photoresist under the exposed negative photoresist; then, taking the silicon wafer out, cleaning it with water, and drying it with a flow of nitrogen. Producing patterns of hollow lines based on the mask patterns.

In selecting developer, when the main components of the selected developer are different, the developer for negative photoresist does not act on the positive photoresist, so as to ensure developing is performed in steps to obtain patterns of highest quality. Meanwhile, the research finds out that the time for performing developing in two steps can be set to be overlaid when the developer for the negative photoresist being used developes the positive photoresist at the same time, so that the positive photoresist is partly developed after removal of unexposed negative photoresist, which does not lead to obvious influence on the patterning of the outer contour as verified by scanning electron microscopy.In summary, before the experiment, a cross-over experiment shall be performed on the positive and negative photoresist and corresponding developer, so as to formulate most suitable process for developing.
(5) transferring the patterns of the contour lines to the material of the substrate through material deposition technology or etching technology, wherein material deposition technology includes electrochemical deposition, electroplating, CVD deposition, laser sputtering, magnetron sputtering, thermal evaporation, electron beam evaporation or atomic deposition. The etching technology includes wet etching including electrochemical etching or selective etching liquid etching or dry etching including ion etching or chemical reactive ion etching.
(6) removing the photoresist.

### <Photolithography System>

The present invention also provide a photolithography system for implementing the photolithography method based on bilayer photoresist as described above, the system comprising a spin coating device, a drying device, an exposing device, a developing device, a deposition and etching device and a photoresist removing device. Specifically, the system can be used to perform the following steps:
spin coating, by the spin coating device, one layer of positive photoresist on a substrate, and drying, by the drying device, the same; spin coating, by the spin coating device, one layer of negative photoresist matching the positive photoresist on the positive photoresist, and drying, by the drying device, the same;
(2) exposing, by the exposing device, two layers of photoresists once using photolithography masks with mask patterns or through focused direct write under the source of exposure, so as to form exposure patterns of different sizes on the negative photoresist and the positive photoresist respectively, and then drying, by the drying device, the negative and positive photoresists;
(3) developing, by the developing device, the negative photoresist with developer for negative photoresist;
(4) controllably developing, by the developing device, the positive photoresist with developer for positive photoresist to merely wash away the edge portions of the exposure patterns on the positive photoresist and uncover the material of the substrate;
(5) forming, by the deposition and etching device, patterns on the material of the substrate through material deposition technology or etching technology;
(6) removing, by the photoresist removing device, the photoresist.

The present invention also provide a method of controlling a photolithography system for controlling the steps performed by the photolithography system described above.

The present invention also provide a computer device comprising a memory, a processor, and computer program that is stored in the memory and can run on the processor, characterized in that the processor implements the method of controlling a photolithography system described above when executing the computer program.

The present invention also provides a computer readable medium having computer program stored thereon, which when executed by a processor implements the method of controlling photolithography system described above.

### <Embodiments>

The specific embodiments of the photolithography method based on bilayer photoresist of the present invention are described in details below.

### Embodiment 1

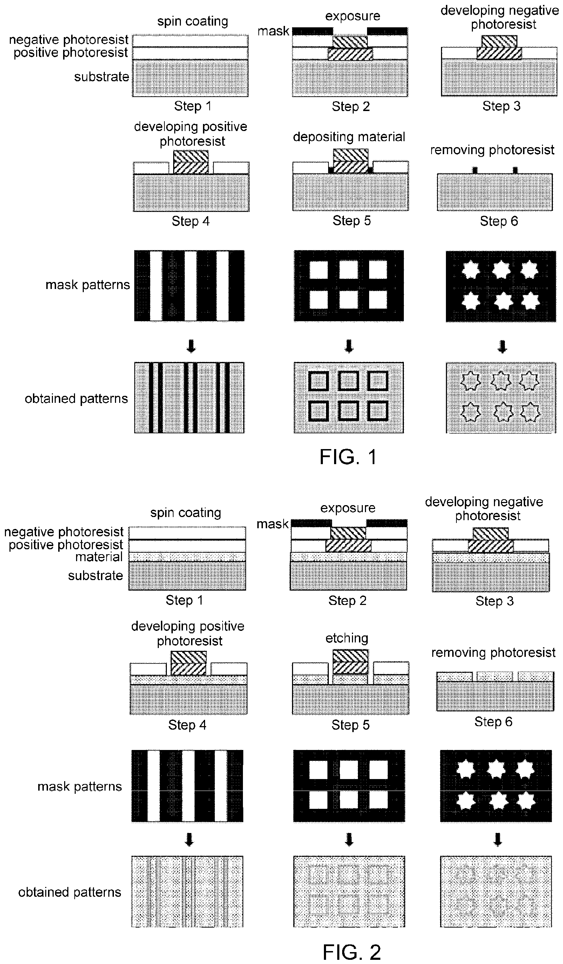

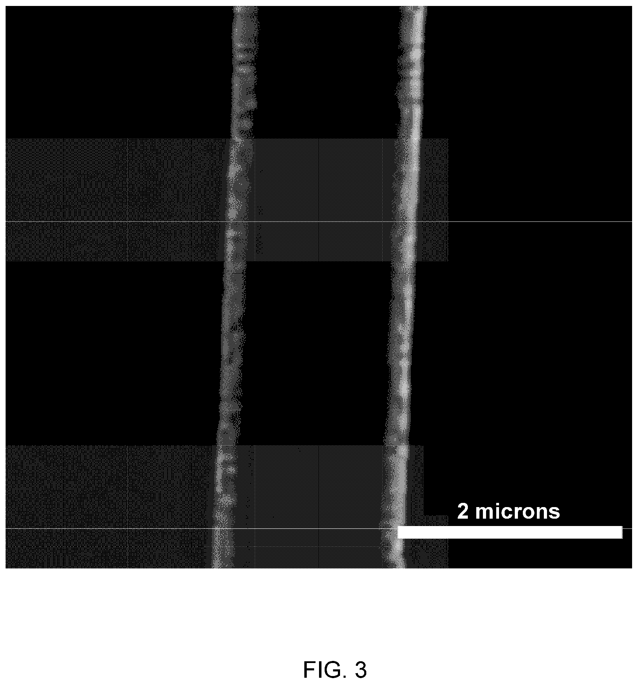

In Embodiment 1, a process for preparing arrays of gold nanowire based on photolithograph technology with bilayer photoresist of positive photoresist and negative photoresist is shown in Fig. 1, comprising the following steps:
(1) cleaning a silicon wafer:
   ultrasonic cleaning the silicon wafer with concentrated sulfuric acid for 20-30 minutes;
   ultrasonic cleaning the silicon wafer with deionized water for 20-30 minutes;
   ultrasonic cleaning the silicon wafer with ethyl alcohol for 20-30 minutes;
   drying the substrate of the silicon wafer with nitrogen, placing the silicon wafer in a dry etcher, and cleaning it with oxygen plasma etching for 1-2 minute.
(2) spinning coating positive photoresist
   Placing the silicon wafer that has been cleaned in a spin coater and fixing it in vacuum. Drop coating, by a dropper, 2-4 drops of positive photoresist SPR 660 or AZ 1500; spin coating the positive photoresist under the condition of 800 rpm×5 s+2500 rpm×30 s; drying the positive photoresist at 95 - 100°C for 40 seconds.
(3) spinning coating negative photoresist
   Placing the silicon wafer that has been cooled in a spin coater and fixing it in vacuum.Drop coating, by a dropper, 2-4 drops of negative photoresist SU-8 2 or AZ nlof 2020; spin coating the negative photoresist under the condition of 1000 rpm×5 s+4000 rpm×40 s; drying the negative photoresist at 100 - 110°C for 60 seconds.
(4) ultraviolet exposure
   Tightly fixing the substrate of the silicon wafer which has undergone the above process under a mask of arrays of 5-micro lines, vacuumizing and placing the silicon wafer right under the ultraviolet light source, turning on the light source to perform photolithography. Adjusting the exposure time according to the kind of paired group of photoresist and the thickness of the layer of photoresist. After the exposure is finished, taking down the mask, and moving the exposed silicon wafer to the heating stage, and baking it at 100 °C for 45 seconds. The exposure flux is e.g., 100 mJ/cm², which can be changed according to needs.
(5) developing
   After post-drying is finished and the silicon wafer has been cooled to the room temperature, performing developing respectively, the process is as follows: placing the silicon wafer after photolithograph in a corresponding developer SU-8 developer or TMAH-2.38% for negative photoresist and causing the unexposed negative photoresist on the silicon wafer to be washed away; then taking out the silicon wafer, cleaning it with deionized water and drying it with a flow of nitrogen; (Note: the steps of cleaning with deionized water and drying with nitrogen can be omitted if the developer is same for positive and negative photoresist)
   Further placing the silicon wafer in corresponding developer MF-26A or TMAH-2.38% for positive photoresist, not completely removing the unexposed positive photoresist under the exposed negative photoresist; then taking out the silicon wafer, cleaning it with water, and drying it with a flow of nitrogen. Producing patterns of contour lines based on the mask patterns.
(6) material deposition
   Placing the silicon wafer that has been developed in an evaporation coater, vacuumizing, by a molecular pump to 10⁻⁶ Pa, and thermal evaporating a titanium film of 5 nm and a gold film of 50 nm at rates of 1 Å/s and 0.5 Å/s respectively. The titanium film of 5 nm is used as an adhesion layer for the gold film.
(7) removing the photoresist.
   After the chamber is cooled, breaking vacuum in the chamber and taking out the coated silicon wafer.Immersing the silicon wafer in the acetone, untrasonic cleaning it until the photoresist is completely removed, leaving patterns of gold nanowires of line widths of ~200 nm. A scanning electron micrograph of the gold nanowire obtained by this method is shown in Fig. 3, which a feature line width of less than 200 nm.

### Embodiment 2

In Embodiment 2, a process of producing contour patterns of silicon oxide on the surface of a silicon wafer of which the surface a film of silicon oxide of a thickness of 100 nm is grown based on the photoresist technology based on bilayer photoresist of positive and negative photoresist is shown in Fig. 2, specifically comprising the following steps:
(1) spinning coating positive photoresist
   Spin coating the silicon wafer with silicon oxide with positive photoresist SPR 660 or AZ 1500 at 2500 rpm for 30-40 seconds, and baking it at 95-100°C for 40 seconds.
(2) spinning coating negative photoresist
   Placing the silicon wafer that has been cooled in a spin coater and fixing it in vacuum.Spin coating it with negative photoresist SU-8 2 or AZ nlof 2020 at 4000 rpm, and baking it at 100-110°C for 60 seconds.
(3) ultraviolet exposure
   Tightly fixing the substrate of the silicon wafer which has undergone the above process under a mask with square patterns, vacuumizing and placing the silicon wafer right under the ultraviolet light source, turning on the light source to perform photolithography. Adjusting the exposure time according to the kind of paired group of photoresist and the thickness of the layer of the photoresist. After the exposure is finished, taking down the mask, and moving the exposed silicon wafer to the heating stage, and baking it at 100°C for 45 seconds. The exposure flux is e.g., 100 mJ/cm², which can be changed according to needs.
(4) developing
   After post-drying is finished and the silicon wafer has been cooled to the room temperature, performing developing respectively, the process is as follows: placing the silicon wafer after photolithograph in developer SU-8 developer or TMAH-2.38% for negative photoresist and causing the unexposed negative photoresist on the silicon wafer to be washed away; then taking out the silicon wafer, cleaning it with deionized water and drying it with a flow of nitrogen; (Note: the steps of cleaning with deionized water and drying with nitrogen can be omitted if the developer is same for positive and negative photoresist)
   Further placing the silicon wafer in developer MF-26A or TMAH-2.38% for positive photoresist, not completely removing the unexposed positive photoresist under the exposed negative photoresist; then taking out the silicon wafer, cleaning it with water, and drying it with a flow of nitrogen. Producing patterns of lines of square contour based on the mask patterns.
(5) dry etching
   Placing the silicon in an ion etcher, etching the mask layer of silicon dioxide with plasma gas to remove the layer of silicon dioxide that has been deposited in advance at the patterns of lines of square contour, causing the underlying silicon substrate to be uncovered.
(6) removing the photoresist.
   Immersing the silicon wafer in acetone, ultrasonic cleaning it under the photoresist is completely removed so as to produce lines of square contour of silicon dioxide.

### Embodiment 3

Regarding exposure, Embodiments 1 and 2 use such a way of exposure in which the substrate is tightly fixed under the mask, the chamber is vacuumized and the silicon wafer is placed right under the ultraviolet light source, but the present invention is not limited thereto. For example, the photolithography technology based on bilayer of photoresist of positive and negative photoresists can also use projection exposure. Described below are the main steps of the photolithography technology based on bilayer photoresist of positive and negative photoresists in Embodiment 3, in which an ultraviolet projection photolithography system with a ultraviolet radiation of a wavelength of less than 400 nm is taken as an example.
(1) spinning coating positive photoresist
   Placing the silicon wafer that has been cleaned in a spin coater and fixing it in vacuum.Drop coating, by a dropper, positive photoresist, spin coating the positive photoresist under the condition of 500 rpm×5 s+4000 rpm×40 s, and baking the positive photoresist at 130°C for 10 seconds.
(2) spinning coating negative photoresist
   Placing the silicon wafer that has been cooled in a spin coater and fixing it in vacuum.Drop coating, by a dropper, negative photoresist, spin coating the negative photoresist under the condition of 500 rpm×5 s+4000 rpm×40 s, and baking the negative photoresist at 90°C for 60 seconds.
(3) projection ultraviolet exposure
   Tightly fixing the silicon wafer that has undergone the above steps on a sample stage of a photolithography machine, and performing projection ultraviolet exposure. Adjusting the exposure time according to the kind of paired group of photoresist and the thickness of the layer of photoresist. After the exposure is finished, moving the exposed silicon wafer to the heating stage, and baking it at 110 °C for 90 seconds. The exposure flux is e.g., 100 mJ/cm², which can be changed according to needs.
(4) developing
   After developing is finished and the silicon wafer has been cooled to room temperature, performing developing respectively. The process is as follows: placing the silicon wafer after photolithography in developer for negative photoresist (TMAH-2.38%) to cause the unexposed negative photoresist on the silicon wafer to be washed away.
   Partly developing, with developer for positive photoresist (TMAH-2.38%) to remove the unexposed positive photoresist under the exposed negative photoresist; then taking out the silicon wafer, cleaning it with water, and drying it with a flow of nitrogen. Producing patterns of contour lines based on the mask patterns.
(5)Subsequently, implementing raised or recessed structures by further combining the steps of material deposition or dry/wet etching etc. Those steps are not repeated here because there are similar to the steps (6), (7) in Embodiment 1 and step (5) in Embodiment 2.

### Embodiment 4

Regarding exposure, Embodiments 1 and 2 use such a way of exposure in which the substrate is tightly fixed under the mask, the chamber is vacuumized and the silicon wafer is placed right under the ultraviolet light source, and Embodiment 3 uses projection exposure. However, the present invention is not limited thereto. For example, the photolithography technology based on bilayer of photoresist of positive and negative photoresists can also use electron beam direct write exposure. Described below are the main steps of the photolithography technology based on bilayer photoresist of positive and negative photoresists using electron beam direct write exposure in Embodiment 4.

### (1) spinning coating positive photoresist

Placing the silicon wafer that has been cleaned in a spin coater and fixing it in vacuum. Drop coating positive electron beam photoresist PMMA, spin coating the photoresist, and pre-drying the photoresist.

### (2) spinning coating negative photoresist

Placing the silicon wafer that has been cooled in a spin coater and fixing it in vacuum. Drop coating negative electron beam photoresist HSQ, spin coating the photoresist, and pre-drying the photoresist.

### (3) electron beam direct write exposure

Placing the substrate of the silicon wafer that has undergone the above steps in an electron beam direct write system to perform electron beam direct write. Adjusting the exposure dose according to the kind of paired group of photoresist and the thickness of the layer of photoresist.After the electron direct write is finished, moving the exposed silicon wafer to a heating stage, and post-drying the silicon wafer. The exposure flux is e.g., 500 µC/cm², which can be changed according to needs.

### (4) developing

After developing is finished and the silicon wafer has been cooled to room temperature, performing developing respectively. The process is as follows: placing the silicon wafer after photolithography in developer for negative electron beam photoresist (TMAH developer) to cause the unexposed negative photoresist on the silicon wafer to be washed away; then taking out the silicon wafer, cleaning it with water, and drying it with a flow of nitrogen.

Further placing the silicon wafer in developer for positive electron beam photoresist (MIBK:IPA developer), partly removing the unexposed positive photoresist PMMA under the exposed negative photoresist; then taking out the silicon wafer, cleaning it with water, and drying it with a flow of nitrogen. Producing patterns of contour lines based on the mask patterns.

(5)Subsequently, implementing raised or recessed structures by further combining the steps of material deposition or dry/wet etching etc. Those steps are not repeated here because there are similar to the steps (6), (7) in Embodiment 1 and step (5) in Embodiment 2.

### Embodiment 5

Regarding exposure, Embodiments 1 and 2 use such a way of exposure in which the substrate is tightly fixed under the mask, the chamber is vacuumized and the silicon wafer is placed right under the ultraviolet light source, Embodiment 3 uses projection exposure, and Embodiment 4 uses electron beam direct write exposure. However, the present invention is not limited thereto. For example, the photolithography technology based on bilayer of photoresist of positive and negative photoresists can also use ultraviolet direct write exposure. Described below are the main steps of the photolithography technology based on bilayer photoresist of positive and negative photoresists using ultraviolet direct write exposure in Embodiment 5.

### (1) spinning coating positive photoresist

Placing the silicon wafer that has been cleaned in a spin coater and fixing it in vacuum. Drop coating, by a dropper, positive photoresist (e.g., AZ 1500), spin coating the positive photoresist under the condition of 500 rpm×5 s+4000 rpm×40 s, and baking the positive photoresist at 100 °C for 10 seconds.

### (2) spinning coating negative photoresist

Placing the silicon wafer that has been cooled in a spin coater and fixing it in vacuum. Drop coating, by a dropper, negative photoresist (e.g., AZ nlof 2020), spin coating the negative photoresist under the condition of 500 rpm×5 s+4000 rpm×40 s, and baking the negative photoresist at 110°C for 60 seconds.

### (3) ultraviolet direct write exposure

Tightly fixing the substrate of the silicon wafer that has undergone the above steps under the source of exposure, turning on the ultraviolet direct write system to perform direct write exposure. Adjusting the exposure time according to the kind of paired group of photoresist and the thickness of the layer of photoresist. After the exposure is finished, taking down the mask, and moving the exposed silicon wafer to the heating stage, and baking it at 110 °C for 60 seconds. The exposure flux is e.g., 100 mJ/cm², which can be changed according to needs.

### (4) developing

After developing is finished and the silicon wafer has been cooled to room temperature, performing developing respectively. The process is as follows: placing the silicon wafer after photolithography in developer for negative photoresist (TMAH-2.38%) to cause the unexposed negative photoresist on the silicon wafer to be washed away.

Partly developing, with developer for positive photoresist (TMAH-2.38%) to remove the unexposed positive photoresist under the exposed negative photoresist; then taking out the silicon wafer, cleaning it with water, and drying it with a flow of nitrogen. Producing patterns of contour lines based on the mask patterns.

(5)Subsequently, implementing raised or recessed structures by further combining the steps of material deposition or dry/wet etching etc. Those steps are not repeated here because there are similar to the steps (6), (7) in Embodiment 1 and step (5) in Embodiment 2.

The above are merely preferred embodiments of the present invention but as limitation of other forms to the present invention. Any technician familiar with the industry can make use of the technical contents as disclosed above and modify and alter them to equivalent embodiments which equivalently vary. However, any simple modification, equivalent change and modification of the above embodiments that are not deviated from the content of the technical solutions of the present invention and based on the technical essence of the present invention still belong to the scope of protection of the technical solutions of the present invention.

### Industrial Applicability

The photolithography method based on bilayer photoresist can be widely used in the technical fields of semiconductor process, chip manufacturing, etc. and has extensive values of research and application.

## Claims

1. A photolithography method based on bilayer photoresist, **characterized in that** the method comprises the following steps:
(1) spin coating one layer of positive photoresist on a substrate, and drying the positive photoresist; further spin coating one layer of negative photoresist matching the positive photoresist on the positive photoresist, and drying the negative photoresist;
(2) exposing two layers of photoresists using photolithography masks with mask patterns or through focused direct write under a source of exposure so as to form exposure patterns of different sizes on the negative photoresist and the positive photoresist respectively, and then drying the negative photoresist and the positive photoresist;
(3) developing the negative photoresist with developer for negative photoresist;
(4) controllably developing the positive photoresist with developer for the positive photoresist to merely wash away edge portions of the exposure patterns on the positive photoresist and uncover the material of the substrate;
(5) forming patterns on the material of the substrate through material deposition technology or etching technology;
(6) removing the photoresist.

2. The photolithography method based on bilayer photoresist according to claim 1, **characterized in that**:
transforming the mask patterns to patterns of contour lines by performing step (4),
transferring the pattern of contour lines to the material of the substrate by performing step (5).

3. The photolithography method based on bilayer photoresist according to claim 1, **characterized in that**:
the process of spin coating comprises: spin coating at a rotation speed of 500 to 8000 rpm, and the temperature for drying after the spin coating is 30 to 300 °C.

4. The photolithography method based on bilayer photoresist according to claim 1, **characterized in that**:
the exposing is in the form of single exposure.

5. The photolithography method based on bilayer photoresist according to claim 1, **characterized in that**:
the exposing is in the form of multiple exposures.

6. The photolithography method based on bilayer photoresist according to claim 1, **characterized in that**:
the source of exposure include ultraviolet light source, deep ultraviolet light source, extreme ultraviolet light source, ion beam, electron beam or X-ray.

7. The photolithography method based on bilayer photoresist according to claim 1 or 6, **characterized in that**:
the wavelength of the source of exposure is 1 to 500 nm, and the temperature for the drying after the exposing is 30 to 300 °C.

8. The photolithography method based on bilayer photoresist according to claim 1, **characterized in that**:
the positive photoresist includes positive ultraviolet photoresist, positive deep ultraviolet photoresist, positive extreme ultraviolet photoresist, positive electron beam photoresist, positive ion beam photoresist or positive X-ray photoresist;
the negative photoresist includes negative ultraviolet photoresist, negative deep ultraviolet photoresist, negative extreme ultraviolet photoresist, negative electron beam photoresist, negative ion beam photoresist or positive X-ray photoresist.

9. The photolithography method based on bilayer photoresist according to claim 1, **characterized in that**:
the developer is developer corresponding to the used photoresist.

10. The photolithography method based on bilayer photoresist according to claim 1, **characterized in that**:
the feature line width or feature dimension of the mask patterns is 2 nm to 1000 µm.

11. The photolithography method based on bilayer photoresist according to claim 1, **characterized in that**:
the material deposition technology includes but not limited to electrochemical deposition, electroplating, CVD deposition, laser sputtering, magnetron sputtering, thermal evaporation, electron beam evaporation or atomic deposition;
the etching technology includes wet etching including electrochemical etching or selective etching liquid etching or dry etching including ion etching or chemical reactive ion etching.

12. The photolithography method based on bilayer photoresist according to claim 1, **characterized in that**:
in step (2), exposing, by means of projection exposure and under the source of exposure, the two layers of photoresist through a photolithography mask with mask patterns.

13. The photolithography method based on bilayer photoresist according to claim 1, **characterized in that**:
in step (2), exposing, by means of masking exposure and under the source of exposure, the two layers of photoresist through a photolithography mask with mask patterns.

14. The photolithography method based on bilayer photoresist according to claim 1, **characterized in that**:
in step (2), exposing, by means of reflection exposure and under the source of exposure, the two layers of photoresist through reflecting on a photolithography mask with mask patterns.

15. The photolithography method based on bilayer photoresist according to claim 1, **characterized in that**:
the focused direct write includes but not limited to ultraviolet direct write, deep ultraviolet direct write, extreme ultraviolet direct write, ion beam direct write, electron beam direct write or X-ray direct write.

16. The photolithography method based on bilayer photoresist according to claim 1, **characterized in that**:
the material of the substrate includes semiconductor, metal, insulator, polymer or composite material.

17. A photolithography system comprising a spin coating device, a drying device, an exposing device, a developing device, a deposition and etching device, and a photoresist removing device, the photolithography system used to perform the following steps:
(1) spin coating, by the spin coating device, one layer of positive photoresist on a substrate, and drying, by the drying device, the positive photoresist; further spin coating, by the spin coating device, one layer of negative photoresist matching the positive photoresist on the positive photoresist, and drying, by the drying device, the negative photoresist;
(2) exposing, by the exposing device, two layers of photoresists using photolithography masks with mask patterns or through focused direct writing under the source of exposure, so as to form exposure patterns of different sizes on the negative photoresist and the positive photoresist respectively, and then drying, by the drying device, the negative photoresist and the positive photoresist;
(3) developing, by the developing device, the negative photoresist with developer for negative photoresist;
(4) controllably developing, by the developing device, the positive photoresist with developer for positive photoresist to merely wash away edge portions of the exposure patterns on the positive photoresist and uncover the material of the substrate;
(5) forming, by the deposition and etching device, patterns on the material of the substrate through material deposition technology or etching technology;
(6) removing, by the photoresist removing device, the photoresist.

18. A method of controlling photolithography system for controlling the steps performed by the photolithography system of claim 17.

19. A computer device comprising a memory, a processor, and computer program that is stored in the memory and can run on the processor, **characterized in that** the processor implements the method of controlling a photolithography system of claim 18 when executing the computer program.

20. A computer readable medium having computer program stored thereon, which when executed by a processor implements the method of controlling photolithography system of claim 18.
